# EUROPEAN PATENT APPLICATION

(11) **EP 3 745 144 A1**
(43) Date of publication of application: **02.12.2020**
(21) Application number: 19177199.7
(22) Date of filing: 29.05.2019
(51) Int. Cl.: G01R 27/26

(54) **A METHOD OF INSPECTING A RADIO FREQUENCY DEVICE AND A RADIO FREQUENCY DEVICE**

(71) Applicant: ALCAN Systems GmbH, 64293 Darmstadt (DE)
(72) Inventor: WEICKHMANN, Christian, 64285 Darmstadt (DE)
(74) Representative: Habermann Intellectual Property Partnerschaft von Patentanwälten mbB

(57) **Abstract**

The invention relates to a method of inspecting a radio frequency device (1) that allows for a modification of the transmission and/or a manipulation of the radio frequency signal along electroconductive elements (13) by changing dielectric material properties of a tunable dielectric material (4) next or nearby the electroconductive elements (13), said method including the following steps of emitting a light beam (12) through an optically transparent area section of a first substrate layer (2) into a test volume of the tunable dielectric material (4) with an inbound light intensity and/or with a known inbound phase before passing through the tunable dielectric material (4), of applying a bias field to a test volume via a first transparent test electrode (6) arranged at an optically transparent area section of the first substrate layer (2) and a second test electrode (8) arranged opposite to the first test electrode at a second substrate layer (3), of measuring an outgoing light intensity and/or an outgoing phase of the light beam (12) after passing through the tunable dielectric material (4) in dependency of the bias field, and of determining at least one characteristic property of the tunable dielectric material (4) on the basis of a quotient of the outgoing light intensity and the incoming light intensity and/or on the basis of a phase relation between the inbound phase and the outgoing phase of the light beam (12) from the bias field.

## Description

### Technical field

The invention relates to a method of inspecting a radio frequency device having an insulating first substrate layer, an insulating second substrate layer, a tunable dielectric material arranged between the first substrate layer and the second substrate layer, and electroconductive elements transmitting a radio frequency signal, wherein the electroconductive elements are arranged at or near the first and/or second substrate layer, and wherein a transmission of the radio frequency signal along the electroconductive elements can be modified by changing dielectric material properties of the tunable dielectric material next or nearby the electroconductive elements, whereby said method includes the step of determining at least one characteristic property of the tunable dielectric material that depends of a bias field applied to the tunable dielectric material.

In radio frequency devices comprising a tunable dielectric material adjacent or near electroconductive elements a transmission characteristic for a radio frequency signal propagating along the electroconductive elements can be modified by tuning dielectric material properties of the tunable dielectric material. Radio frequency comprises a frequency range of at least 30 kHz to 300 GHz. While the dielectric material properties of a bulk form of the tunable dielectric material used for manufacturing the radio frequency device might be known the dielectric material properties of the tunable dielectric material comprised in the radio frequency device is generally subject to production related fluctuations. Hence, an inspection based upon acquiring the dielectric material properties of the tunable dielectric material of the radio frequency device becomes a necessity. Typically, the dielectric material properties of the tunable dielectric material are measured with an electronic testing equipment to which the radio frequency device has to be connected electroconductively. Especially in case of a radio frequency device with a plurality of electroconductive elements each requiring a separate inspection the inspection can be very time-consuming and costly.

Accordingly, there is a need to provide for a more rapid method of inspecting a radio frequency device.

### Summary of the invention

The present invention relates to a method of inspecting a radio frequency device described above, wherein at least one characteristic property of the tunable dielectric material is determined from an optical measurement of the optical material properties of the tunable dielectric material in the following steps:
a) emitting a light beam through an optically transparent area section of the first substrate layer into a test volume of the tunable dielectric material with an inbound light intensity and/or with a known inbound phase before passing through the tunable dielectric material,
b) applying the bias field to the test volume via a first transparent test electrode arranged at the optically transparent area section of the first substrate layer and a second test electrode arranged opposite to the first test electrode at the second substrate layer,
c) measuring an outgoing light intensity of the light beam and/or measuring an outgoing phase of the light beam with respect to the inbound phase after passing through the tunable dielectric material depending on the bias field,
d) determining the at least one characteristic property of the tunable dielectric material on the basis of a quotient of the outgoing light intensity and the incoming light intensity and/or on the basis of a phase relation between the inbound phase and the outgoing phase of the light beam from the bias field.

Thus, the dielectric material properties of the tunable dielectric material that is comprised within the radio frequency device can be measured in a simplified and rapid fashion without the need to electroconductively connect the radio frequency device to an electronic testing equipment. The required measurements of either the light intensity or the phase relation of the light beam, or even both, can be performed with commercially available measurement devices. The measurements can be performed at a distance to the test volume and without need to provide for a contact between the measurement device and the radio frequency device with the test volume.

The emitted light beam can originate from a continuous light source or from a monochromatic light source as a e.g. a laser. According to an advantageous embodiment of the invention the light beam is polarized. The light beam can be focused on an overlapping area section of the first transparent electrode and the second test electrode.

At least the optically transparent area section of the first substrate layer and preferably the complete first substrate layer is made of glass or of a synthetic optically transparent material.

It is possible that after applying the bias field a plurality of measurements is performed at one given bias field to determine a time dependency of a change of the outgoing light intensity. On the basis of the time dependency of the outgoing light intensity a switching time of the tunable dielectric material can be determined. It is also possible that the bias field is swept in incremental steps and the outgoing light intensity is measured once for each incremental step. Thus, from the dependency of the outgoing light intensity with the bias field a tunability of the tunable dielectric material can be established e.g. on the basis of a look up table. The look up table can for instance be created by correlating the tunability of the dielectric material with a change in the outgoing light intensity of the tunable dielectric material.

According to an advantageous embodiment of the method, within step c) the outbound light intensity or the phase relation of the outgoing phase with respect to the inbound phase is measured from the light beam that is reflected back through the optically transparent area section of the first substrate. For instance, in case the second test electrode is fabricated from a metal the light beam having traversed the tunable dielectric material can be reflected at the second test electrode and transverse the tunable dielectric material again to exit the tunable dielectric device through the optically transparent area section of the first substrate.

According to yet another advantageous aspect of the invention, the second test electrode is optically transparent and arranged on an optically transparent area section of the second substrate layer, and in step c) the outbound light intensity or the phase relation of the outgoing phase with respect to the inbound phase is measured from the light beam transmitted through the optically transparent second test electrode arranged on an optically transparent area section of the second substrate layer. In such a way the outbound light intensity can be measured from the light beam that traverses through the radio frequency device.

The invention also relates to a radio frequency device comprising an insulating first substrate layer, an insulating second substrate layer, a tunable dielectric material arranged between the first substrate layer and the second substrate layer, and electroconductive elements that allow for transmission of a radio frequency signal, wherein the electroconductive elements are arranged at or near the first and/or second substrate layer, and wherein a transmission of the radio frequency signal along the electroconductive elements can be modified by changing dielectric material properties of the tunable dielectric material next or nearby the electroconductive elements.

Such radio frequency devices are known in the art. For instance, WO 2014/125095 A1 describes a phase shifting device comprising a transmission line, where electroconductive elements are arranged next to a tunable dielectric material and where transmission properties of the transmission line can be modified by tuning dielectric material properties of the tunable dielectric material. The dielectric material properties of the tunable dielectric material comprised in the radio frequency device can exhibit production related fluctuations. The dielectric material properties of the tunable dielectric material are typically measured with an electronic testing equipment as an LCR-meter, an impedance spectrometer or a network analyzer, to which the radio frequency device has to be connected electroconductively. Contacting the radio frequency device as well as performing the measurements with said electronic testing equipment can be very time-consuming. This problem is all the greater in case that the functioning and operation of a phased array antenna must be determined, whereby the phased array antenna includes a large number of phase shifting devices e.g. on a single chip. It is known that a full testing of a phased array antenna comprising e.g. thousand phase shifting devices may require some days of testing work.

Accordingly, there is a need for a radio frequency device allowing for a more rapid characterization of the dielectric properties of the tunable dielectric material.

The present invention relates to a radio frequency device as described above, wherein a change in the dielectric material properties effects a change in optical material properties of the tunable dielectric material, wherein the radio frequency device further comprises a first optically transparent test electrode arranged on an optically transparent area section of the first substrate layer, a second test electrode arranged on the second substrate layer opposite to the first test electrode and overlapping with the first test electrode creating a test capacitor in an overlapping area between the first test electrode and the second test electrode, so that a bias field can be applied to the tunable dielectric material within the test capacitor and that a light beam directed through the optical transparent area section of the first substrate layer at the tunable dielectric material within the test capacitor can be used for measuring at least one optical material property of the tunable dielectric material within the test capacitor which allows for determining at least one of the characteristic properties of the tunable dielectric material in dependency of the applied bias field.

Thus, the optical material properties of the tunable dielectric material can be measured in dependency of the applied bias field. The change effected in the optical material with changing the dielectric material properties by changing the bias field can for instance be a modification of the attenuation of the light beam passing through the tunable dielectric material, or a modification of a polarization direction of the light beam, or a modification of the phase relation of an inbound and an outgoing light beam. On the basis of the measured change of intensity of the light beam that traverses the tunable dielectric material, e.g. a switching time or a tunability of the tunable dielectric material can be determined.

According to an embodiment of the invention, the second test electrode and/or at least an area section of the second substrate layer overlaying with the test capacitor are made of an optically reflective material or are covered by an optically reflective material. The light beam that is directed through the optically transparent area section of the first substrate layer, through the optically transparent first test electrode and through the tunable dielectric material will be reflected and traverses again the optically transparent first test electrode and the optically transparent area section of the first substrate layer until the light beam exits the radio frequency device and can be measured for determination of the properties of the tunable dielectric material arranged inside the radio frequency device.

To allow for an optical measurement with the light beam passing through the radio frequency device, according to an advantageous embodiment of the invention the second test electrode and at least an area section of the second substrate layer overlaying with the test capacitor are optically transparent.

According to an advantageous aspect of the invention the first substrate layer and/or the second substrate layer is optically transparent. This allows for an optical measurement that is laterally not restricted to the transparent area section of the first and/or second substrate layer. The first substrate layer and, if applicable, the second substrate layer are fabricated from an optically transparent material as e.g. quartz or polycarbonate.

According to an advantageous embodiment of the invention the first substrate layer and/or the second substrate layer is fabricated from a silicate glass. The silicate glass can be a borosilicate glass or a soda lime glass. Silicate glass substrates can be manufactured cost efficiently with surfaces with a low surface roughness. Furthermore, glass substrates comprise features that are advantageous for manufacture of phase shifting devices on top of a surface of the glass substrate, and for manufacture of phase array antennas with a large number of phase shifting devices.

To be able to use well-known manufacturing processes for the fabrication of transparent electrodes the first test electrode and/ or the second test electrode may comprise an optically transparent conducting oxide, preferably indium tin oxide and/or indium zinc oxide.

According to an advantageous embodiment of the invention the test capacitor is laterally spaced apart from the electroconductive elements.

According to an advantageous aspect of the invention the test capacitor is arranged close to an edge section of the radio frequency device. Thus, the test capacitor can be integrated in the edge section of the radio frequency device which can be easily left free of the electroconductive elements.

According to an alternative aspect of the invention the test capacitor is laterally arranged adjacent to one of the electroconductive elements. The dielectric material properties of the tunable dielectric material might vary within the radio frequency device. Hence the dielectric material properties can be probed adjacent to each respective electroconductive element to allow for an independent calibration of each of the respective electroconductive elements.

According to an advantageous aspect of the invention at least one of the electroconductive elements is a radio frequency phase shifting element.

According to an advantageous embodiment of the invention the radio frequency device comprises a dedicated test capacitor for each phase shifting element. For instance, in a phased array antenna comprising a multitude of antenna patches, each of the antenna patches can be connected to a dedicated phase shifting element. The radiation characteristic of the phased array antenna is given by a superposition of the characteristics of each of the antenna patches connected to the respective phase shifting element. To allow for a predetermined radiation characteristic of the phased array antenna the calibration of each of the phase shift elements can be necessary. The dedicated test capacitor can allow for calibrating each of the respective phase shifting elements in a rapid fashion.

According to an advantageous embodiment of the invention one of the electroconductive elements is a transmission line, wherein one section of the transmission line forms a gap, and wherein the first test electrode or the second test electrode is arranged within the gap, so that the radio frequency signal can propagate along the transmission line via the respective test electrode. In this way the test capacitor can be incorporated into the transmission line without increasing a foot print of the radio frequency device.

According to an advantageous aspect of the invention at least one of the electroconductive elements is a radiating element. The radiating element can be the antenna pad.

For a simplified manufacturing of the radio frequency device by using existing liquid crystal display manufacturing methods according to an advantageous embodiment of the invention the tunable dielectric material is a liquid crystal material. The liquid crystal material can be a commercially available liquid crystal material. The liquid crystal materials can show a strong correlation of the change of the dielectric properties and the optical properties.

According to an advantageous aspect of the invention the radio frequency device comprises a shielding element, wherein the shielding element is laterally surrounding at least one of the electroconductive elements of the radio frequency device, and wherein the shielding element is comprising the transparent conductive oxide. The shielding element can shield the at least one electroconductive element from electromagnetic disturbances. In case of the radio frequency device with a plurality of the electroconductive elements the shielding element can reduce a cross-talk between the different electroconductive elements. To reduce manufacturing costs of the radio frequency device, the shielding elements can be manufactured in one deposition step together with the test electrodes.

### Brief description of the drawings

Figure 1 illustrates a schematic top view of a radio frequency device,
Figure 2 illustrates a sectional view of the radio frequency device as shown in figure 1 along the line II-II,
Figures 3, 4, and 5 illustrate each a top view of an alternative embodiment of the radio frequency device, and
Figure 6 illustrates a sectional view of the radio frequency device as shown in figure 5 along the line VI-VI.

### Detailed description of the invention

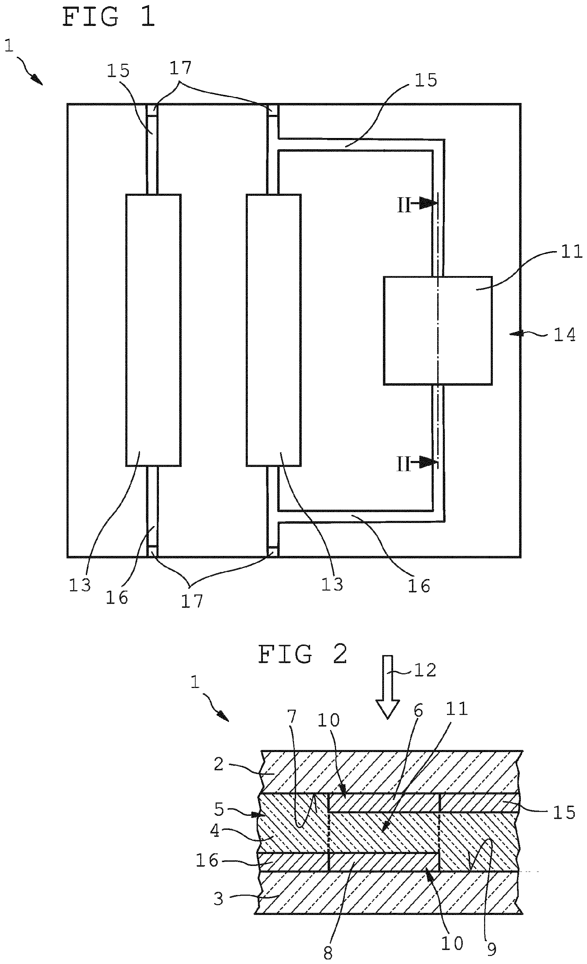

Figure 1 illustrates a top view of a radio frequency device 1 and figure 2 illustrates a sectional view of the radio frequency device 1 as shown in figure 1. The radio frequency device comprises a first substrate layer 2 and a second substrate layer 3 in between which a tunable dielectric material 4 is arranged. In this exemplary embodiment of the radio frequency device 1, the tunable dielectric material 4 is a liquid crystal material 5 and the two substrate layers 2, 3 are silicate glass layers. A first optically transparent test electrode 6 is arranged at an inner surface 7 of the first substrate layer 2 and a second optically transparent test electrode 8 is arranged at an inner surface 9 of the second substrate layer 3. The two test electrodes 6, 8 are formed from an optically transparent conducting oxide 10. An overlapping area of the two transparent test electrodes 6, 8 forms a test capacitor 11. The test capacitor 11 is optically transparent for a traversing light beam 12.

The radio frequency device 1 shown in figure 1 comprises two electroconductive elements 13. In this exemplary embodiment of the radio frequency device 1, the two electroconductive elements 13 are transmission lines running in parallel between the two substrate layers 2, 3. The test capacitor 11 is arranged at an edge section 14 of the radio frequency device 1. The edge section 14 is free of the electroconductive elements 13 and provides for an empty foot-print that can be used for arranging the test capacitor 11 between the two substrate layers 2, 3.

The radio frequency device 1 further comprises first bias lines 15 arranged on the inner surface 7 of the first substrate layer 2 and second bias lines 16 arranged on the inner surface 9 of the second substrate layer 3. By imposing a bias voltage to the bias lines 15, 16 via bias contacts 17 a bias field can be applied to the liquid crystal material 5 near the electroconductive elements 13, changing dielectric material properties of the liquid crystal material 5 and thus modifying transport properties of a radio frequency signal propagating along the electroconductive elements 13. One of the first bias lines 15 is electroconductively connected to the first test electrode 6 and one of the second bias lines 16 is in electroconductively connected to the second test electrode 8 of the test capacitor 11. When imposing the bias voltage at the bias contacts 17 the bias field is thus also applied at the test capacitor 11 and the dielectric material properties of the liquid crystal material 5 inside the test capacitor 11 are changed. The optical material properties of the of the liquid crystal material 5 are modified together with its dielectric properties. Thus, the change of the dielectric properties of the tunable dielectric material 4 can be derived from a modification of the optical properties of the liquid crystal material 5 within the test capacitor 11 dependent on the applied bias field.

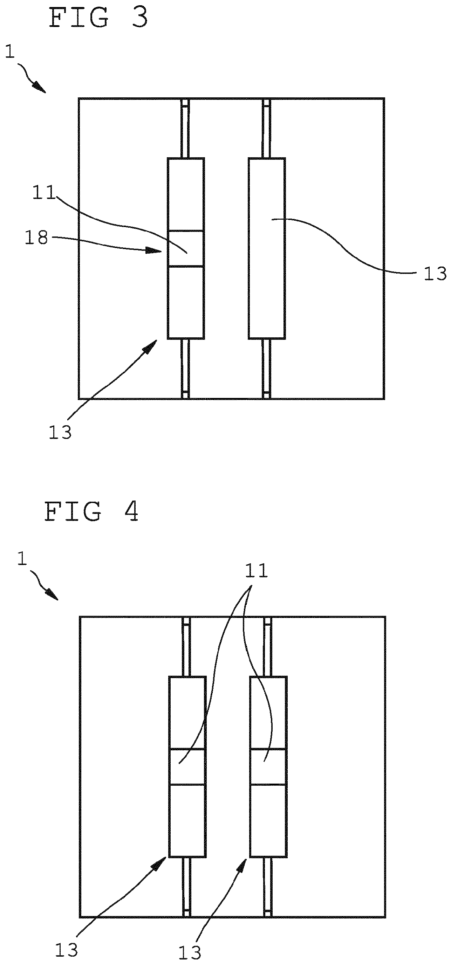

Figure 3 and figure 4 illustrate two alternative embodiments of the radio frequency device 1 with each comprising two electroconductive elements 13. In case of the embodiment of the radio frequency device 1 illustrated in figure 3 the test capacitor 11 of one of the electroconductive elements 13 is arranged in a gap 18 formed by the respective electroconductive element 13. Thus, the dielectric material properties of the tunable dielectric material 4 near the electroconductive element 13 with the gap 18 can be determined from the optical material properties measured using the test capacitor 11.

In case of the embodiment of the radio frequency device 1 illustrated in figure 4 the radio frequency device 1 comprises the two test capacitors 11 with each of the capacitors 11 being dedicated to the respective electroconductive element 13. The test capacitors 11 are arranged in respective gaps 18 of the electroconductive elements 13. In such a way each of the electroconductive elements 13 can be measured and e.g. calibrated independently.

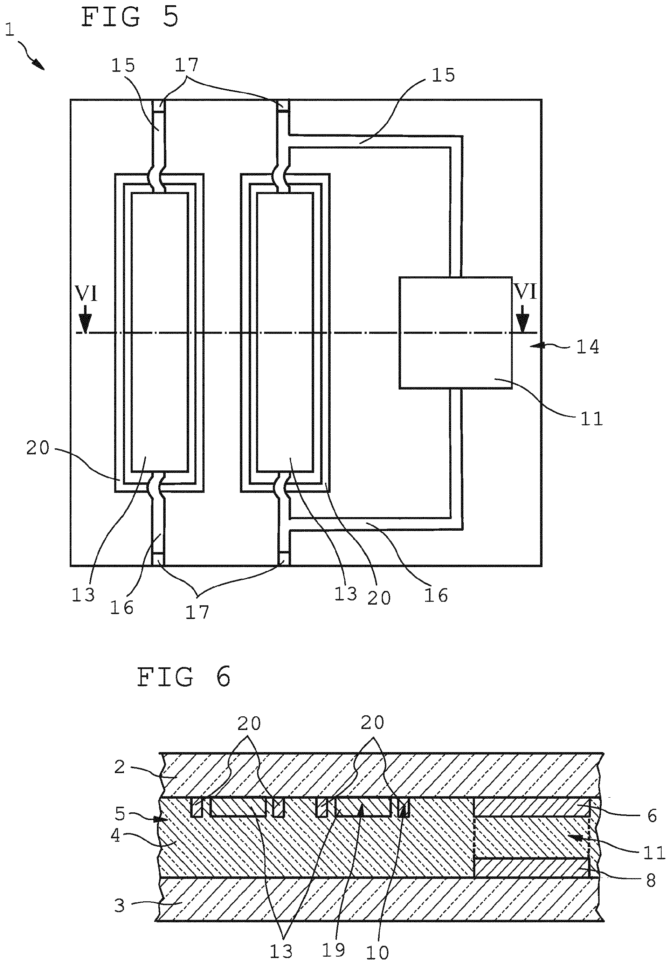

An alternative embodiment of the radio frequency device 1 is illustrated in figure 5 in a top view and in figure 6 in a sectional view. The radio frequency device 1 comprises the two electroconductive elements 13 and the test capacitor 11 arranged in the edge section 14. The two electroconductive elements 13 are formed from a metal with a high electrical conductivity as for instance copper or gold. Each of the electroconductive elements 13 is surrounded by a shielding element 20 formed from the transparent conducting oxide 10. The shielding elements can reduce cross talk between the respective electroconductive elements 13.

## Claims

1. A method of inspecting a radio frequency device (1) having an insulating first substrate layer (2), an insulating second substrate layer (3), a tunable dielectric material (4) arranged between the first substrate layer (2) and the second substrate layer (3), and electroconductive elements (13) for transmitting a radio frequency signal, wherein the electroconductive elements (13) are arranged at or near the first and/or second substrate layer (2, 3), and wherein a transmission of the radio frequency signal along the electroconductive elements (13) can be modified by changing dielectric material properties of the tunable dielectric material (4) next or nearby the electroconductive elements (13), said method including the step of determining at least one characteristic feature of the tunable dielectric material (4) that depends on a bias field applied to the tunable dielectric material (4), **characterized in that** the at least one characteristic feature of the tunable dielectric material (4) is determined from an optical measurement of the optical material properties of the tunable dielectric material (4) in the following steps:
a) emitting a light beam (12) through an optically transparent area section of the first substrate layer (2) into a test volume of the tunable dielectric material (4) with an inbound light intensity and/or with a known inbound phase before passing through the tunable dielectric material (4),
b) applying the bias field to the test volume via a first transparent test electrode (6) arranged at the optically transparent area section of the first substrate layer (2) and a second test electrode (8) arranged opposite to the first test electrode at the second substrate layer (3),
c) measuring an outgoing light intensity of the light beam (12) and/or measuring an outgoing phase with respect to the inbound phase after passing through the tunable dielectric material (4) in dependency of the bias field,
d) determining at least one characteristic property of the tunable dielectric material (4) on the basis of a quotient of the outgoing light intensity and the incoming light intensity and/or on the basis of a phase relation between the inbound phase and the outgoing phase of the light beam (12) from the bias field.

2. A method after claim 1, **characterized in that** in step c) the outbound light intensity or the phase relation of the outgoing phase with respect to the inbound phase is measured from the light beam (12) that is reflected back through the optically transparent area section of the first substrate (2).

3. A method after claim 1, **characterized in that** the second test electrode (8) is optically transparent and arranged on an optically transparent area section of the second substrate layer (3), and that in step c) the outbound light intensity or the phase relation of the outgoing phase with respect to the inbound phase is measured from the light beam (12) transmitted through the optical transparent second test electrode (8) arranged on an optically transparent area section of the second substrate layer (3).

4. A radio frequency device (1) comprising an insulating first substrate layer (2), an insulating second substrate layer (3), a tunable dielectric material (4) arranged between the first substrate layer (2) and the second substrate layer (3), and electroconductive elements (13) that allow for transmission of a radio frequency signal, wherein the electroconductive elements (13) are arranged at or near the first and/or second substrate layer (2, 3), and wherein a transmission of the radio frequency signal along the electroconductive elements (13) can be modified by changing dielectric material properties of the tunable dielectric material next or nearby the electroconductive elements (13), **characterized in that** a change in the dielectric material properties effects a change in optical material properties of the tunable dielectric material (4), wherein the radio frequency device (1) further comprises a first optically transparent test electrode (6) arranged on an optically transparent area section of the first substrate layer (2), a second test electrode (8) arranged on the second substrate layer (3) opposite to the first test electrode (6) and overlapping with the first test electrode (6) creating a test capacitor (11) in an overlapping area between the first test electrode (6) and the second test electrode (8), so that a bias field can be applied to the tunable dielectric material (4) within the test capacitor (11) and that a light beam (12) directed through the optical transparent area section of the first substrate layer (2) at the tunable dielectric material (4) within the test capacitor (11) can be used for measuring at least one optical material property of the tunable dielectric material (4) within the test capacitor (11) which allows for determining at least one of the characteristic properties of the tunable dielectric material (4) in dependency of the applied bias field.

5. A radio frequency device (1) according to claim 4, **characterized in that** the second test electrode (8) and/or at least an area section of the second substrate layer (3) overlaying with the test capacitor (11) are made of an optically reflective material or are covered by an optically reflective material.

6. A radio frequency device (1) according to claim 4, **characterized in that** the second test electrode (8) and at least an area section of the second substrate layer (3) overlaying with the test capacitor (11) are optically transparent.

7. A radio frequency device (1) according to any of the claims 4 to 6, **characterized in that** the first substrate layer (2) and/or the second substrate layer (3) is optically transparent.

8. A radio frequency device (1) according to any of the claims 4 to 7, **characterized in that** the first substrate layer (2) and/or the second substrate layer (3) is fabricated from a silicate glass.

9. A radio frequency device (1) according to any of the claims 4 to 8, **characterized in that** the first test electrode (6) and/ or the second test electrode (8) comprises a transparent conducting oxide (10), preferably indium tin oxide and/or indium zinc oxide.

10. A radio frequency device (1) according to any of the claims 4 to 9, **characterized in that** the test capacitor (11) is laterally spaced apart from the electroconductive elements (13).

11. A radio frequency device (1) according to any of the claims 4 to 10, **characterized in that** the test capacitor (11) is arranged close to an edge section (14) of the radio frequency device (1).

12. A radio frequency device (1) according to any of the claims 4 to 9 and 11, **characterized in that** the test capacitor (11) is laterally arranged adjacent to one of the electroconductive elements (13).

13. A radio frequency device (1) according to any of the claims 4 to 12, **characterized in that** at least one of the electroconductive elements (13) is a radio frequency phase shifting element.

14. A radio frequency device (1) according to claim 13, **characterized in that** the radio frequency device (1) comprises a dedicated test capacitor (11) for each phase shifting element.

15. A radio frequency device (1) according to any of the claims 4 to 9 and 11 to 14, **characterized in that** one of the electroconductive elements (13) is a transmission line, wherein one section of the transmission line forms a gap (18), and wherein the first test electrode (6) or the second test electrode (8) is arranged within the gap, so that the radio frequency signal can propagate along the transmission line via the respective test electrode (6, 8).

16. A radio frequency device (1) according to any of the claims 4 to 15, **characterized in that** at least one of the electroconductive elements (13) is a radiating element.

17. A radio frequency device (1) according to any of the claims 4 to 16, **characterized in that** the tunable dielectric material (4) is a liquid crystal material (5).

18. A radio frequency device (1) according to any of the claims 4 to 17, **characterized in that** the radio frequency device (1) comprises a shielding element (20), wherein the shielding element (20) is laterally surrounding at least one of the electroconductive elements (13) of the radio frequency device (1), and wherein the shielding element (20) is comprising the transparent conductive oxide (10).
